(19) **Europäisches Patentamt / European Patent Office / Office européen des brevets**

(11) **EP 3 248 284 B1**

(12) # FASCICULE DE BREVET EUROPEEN

(45) Date de publication et mention de la délivrance du brevet:
**16.02.2022 Bulletin 2022/07**

(21) Numéro de dépôt: **16701010.7**

(22) Date de dépôt: **19.01.2016**

(51) Classification Internationale des Brevets (IPC):
**H03G 3/12** *(2006.01)* **H03G 7/00** *(2006.01)*
**H03G 7/08** *(2006.01)* *H04R 3/00 (2006.01)*

(52) Classification Coopérative des Brevets (CPC):
**H03G 7/08; H03G 3/12; H03G 7/002; H04R 3/007;**
H04R 2400/00; H04R 2430/01

(86) Numéro de dépôt international:
**PCT/EP2016/051014**

(87) Numéro de publication internationale:
**WO 2016/116444 (28.07.2016 Gazette 2016/30)**

(54) **PROCÉDÉ D'ADAPTATION DU GAIN DE VOLUME POUR LA LIMITATION DE PUISSANCE D'UN AMPLIFICATEUR ET AMPLIFICATEUR**

VERFAHREN ZUR ANPASSUNG DER LAUSTÄRKEVERSTÄRKUNG ZUR LEISTUNGSBEGRENZUNG EINES VERSTÄRKERS SOWIE VERSTÄRKER

METHOD FOR ADAPTING THE VOLUME GAIN FOR THE POWER LIMITATION OF AN AMPLIFIER, AND AMPLIFIER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.01.2015 FR 1550408**

(43) Date de publication de la demande:
**29.11.2017 Bulletin 2017/48**

(73) Titulaire: **Devialet**
**75001 Paris (FR)**

(72) Inventeurs:
- **MENDES, Eduardo**
  **26120 Chabeuil (FR)**
- **CALMEL, Pierre-Emmanuel**
  **78150 Le Chesnay (FR)**

(74) Mandataire: **Lavoix**
**2, place d'Estienne d'Orves**
**75441 Paris Cedex 09 (FR)**

(56) Documents cités:
**US-A1- 2007 036 362    US-A1- 2007 206 820**
**US-A1- 2015 010 168**

**Description**

La présente invention concerne un procédé d'adaptation du gain de volume appliqué dans un amplificateur audio commandant au moins un haut-parleur d'une enceinte en fonction du gain de volume désiré choisi par un utilisateur sur une échelle majorée par un gain de volume désiré maximal.

Un haut-parleur électrodynamique est un dispositif électromécanique qui a pour objet de convertir une tension électrique qui est appliquée à ses bornes en une pression acoustique. En raison de la résistance électrique de la bobine du haut-parleur et du courant qui y circule, un échauffement thermique apparait. Le haut-parleur a une certaine capacité à dissiper dans son environnement, l'énergie thermique qu'il créé. Toutefois, lorsque l'énergie électrique reçue par le haut-parleur produit une énergie thermique supérieure à ce qu'il peut dissiper, la température de la bobine du haut-parleur peut augmenter au-delà d'une valeur permise qui amène à la destruction de la bobine et donc du haut-parleur.

Il est connu de mettre en œuvre des procédés et des dispositifs qui limitent la puissance thermique produite par le haut-parleur, en limitant le courant circulant dans la bobine.

Ces procédés utilisent couramment la tension appliquée au haut-parleur pour l'envoyer dans un modèle dont la sortie est comparée à un seuil pour agir sur la tension appliquée au haut-parleur. Des modèles plus complexes mesurent le courant traversant la bobine. Pour éviter la surchauffe du haut-parleur, le gain de volume désiré par l'utilisateur est réduit automatiquement de manière à limiter la puissance thermique dans le haut-parleur. Le gain de volume désiré est la consigne appliquée par l'utilisateur pour régler le niveau sonore produit par les enceintes. L'utilisateur perçoit cette variation. Pour atténuer la variation perçue par l'utilisateur des constantes de temps limitant la vitesse de variation du gain de volume désiré sont ajoutées au dispositif de limitation de la puissance. Les dispositifs de limitation de la vitesse de variation sont difficiles à régler et la plupart du temps amènent un phénomène de pompage.

L'invention a pour but de permettre de limiter la puissance thermique dissipée par le haut-parleur tout en évitant la perception de la variation de l'énergie fournie au haut-parleur par l'utilisateur et les phénomènes de pompage.

A cet effet, l'invention a pour objet un procédé du type précité, caractérisé en ce qu'il comprend les étapes de :

- détermination de l'intensité efficace appliquée à au moins un haut-parleur,
- calcul d'un gain de volume maximal à partir :

  - du gain de volume désiré,
  - de l'intensité efficace appliquée au haut-parleur,
  - de caractéristiques thermiques du haut-parleur,
  - du gain de volume désiré maximal,

- calcul d'une fonction monotone croissante donnant un gain de volume appliqué variable en fonction du gain de volume désiré telle que l'image du gain de volume désiré maximal par la fonction monotone soit égale au gain de volume maximal,
- application à l'amplificateur, en tant que gain de volume appliqué, du minimum du gain de volume maximal et du gain de volume appliqué variable pour le gain de volume désiré.

Suivant des modes particuliers de mise en oeuvre, le procédé comporte une ou plusieurs des caractéristiques suivantes :

- la fonction monotone est une fonction affine ;
- la fonction monotone est donnée par :

$$\left(G_{Volume}\right)_{\max variable} = \left(G_{Volume}\right)_{\max} \times \left( \alpha + \left(1-\alpha\right) \times \frac{G_{Volume\ désiré} - \left(G_{Volume}\right)_{\max}}{\left(G_{Volume\ désiré}\right)_{\max} - \left(G_{Volume}\right)_{\max}} \right)$$

dans laquelle α est une valeur comprise entre 0 et 1 ;

$(G_{Volume})_{max\ variable}$ est le gain de volume appliqué variable ;
$(G_{Volume})_{max}$ est le gain de volume maximal ;
$(G_{Volume\ désiré})$ est le gain de volume désiré ; et
$(G_{Volume\ désiré})_{max}$ est un gain de volume désiré maximum.

- une étape de calcul du gain de volume maximal individuel est effectuée pour chaque haut-parleur à partir :

- du gain de volume désiré,
- de l'intensité efficace appliquée au haut-parleur,
- de caractéristiques thermiques du haut-parleur,
  et le gain de volume maximal est déterminé à partir des gains de volume maximal individuels.
- le gain de volume maximal est le minimum des gains de volume maximal individuels et du gain de volume désiré maximal.

L'invention a également pour objet un amplificateur comportant :

- des moyens de détermination de l'intensité efficace appliquée à au moins un haut-parleur ;

  - des moyens de calcul d'un gain de volume maximal à partir :
  - du gain de volume désiré,
  - de l'intensité efficace appliquée au haut-parleur,
  - de caractéristiques thermiques du haut-parleur,
  - du gain de volume désiré maximal,

- des moyens de calcul d'une fonction monotone croissante donnant un gain de volume appliqué variable en fonction du gain de volume désiré telle que l'image du gain de volume désiré maximum par la fonction monotone soit égale au gain de volume maximal ; et
- des moyens pour appliquer à l'amplificateur, en tant que gain de volume appliqué, le minimum du gain de volume maximal et du gain de volume appliqué variable pour le gain de volume désiré.

L'invention sera mieux comprise à la lecture de la description qui va suivre donnée uniquement à titre d'exemple et faite en se référant aux dessins sur lesquels :

- la figure 1 est une vue schématique d'une installation de restitution sonore ;
- la figure 2 est un organigramme du procédé de réglage en continu du volume d'amplification ; et
- la figure 3 est une courbe illustrant le volume d'amplification appliqué en fonction du volume d'amplification désiré par mise en oeuvre du procédé de la figure 2.

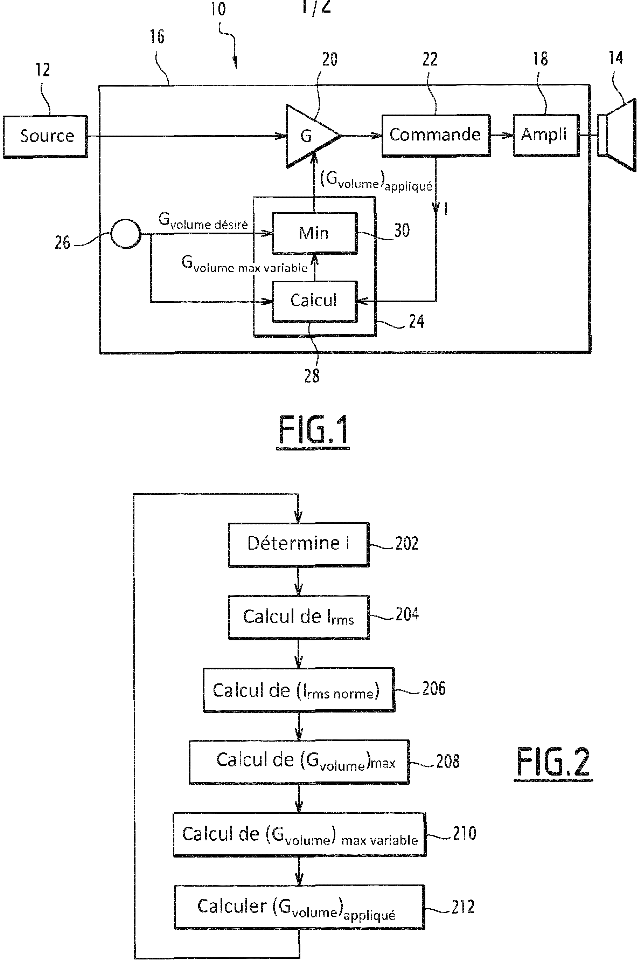

L'installation de restitution sonore 10 illustrée sur la figure 1 comporte un module 12 de production d'un signal audio, tel qu'un lecteur de disque numérique relié à un haut-parleur 14 au travers d'un amplificateur 16.

L'amplificateur 16 comporte un étage d'amplification en tension 18 à la sortie duquel est relié le haut-parleur 14. Entre la source 12 et l'entrée de l'étage d'amplification 18, l'amplificateur comporte un étage 20 d'ajustement du niveau sonore suivant un gain de volume appliqué noté ($G_{Volume}$) appliqué dont la sortie est reliée à un étage de commande 22 propre à fournir un signal d'excitation du haut-parleur qui est fourni à l'unité d'amplification 18.

L'étage de commande 22 est propre notamment à calculer la tension U et l'intensité I devant être appliquées au haut-parleur afin que la membrane du haut-parleur soit à chaque instant dans une position déterminée avec une vitesse, une accélération, une dérivée de l'accélération par rapport au temps propres à reproduire le signal reçu par l'unité de commande 22. En particulier, l'étage de commande 22 est propre à déterminer l'intensité I qui, à chaque instant, va circuler dans le haut-parleur 14 après amplification par l'étage d'amplification 18 en fonction des paramètres dynamiques souhaités pour la membrane du haut-parleur.

L'amplificateur 16 comporte en outre une unité 24 de gestion du volume sonore. Cette unité 24 est propre à définir et à adresser le gain de volume appliqué ($G_{Volume}$)$_{appliqué}$ à l'étage d'ajustement du volume sonore 20, auquel sa sortie est reliée.

L'unité 24 est reliée à des moyens 26 d'entrée d'un gain de volume désiré noté $G_{Volume\ désiré}$ correspondant à une expression du niveau sonore souhaité par l'utilisateur. Ces moyens 26 sont formés par exemple d'un potentiomètre de réglage du volume sonore accessible manuellement par l'utilisateur. Le gain de volume désiré $G_{Volume\ désiré}$ est réglable manuellement sur une échelle depuis une valeur minimale jusqu'à une valeur maximale désignée par ($G_{Volume\ désiré}$)$_{max}$.

L'unité 24 de gestion du volume sonore est reliée à l'étage de commande 22 pour recevoir le courant instantané I.

L'unité 24 comporte des moyens 28 de calcul d'un gain de volume appliqué variable ($G_{Volume}$)$_{max}$ variable et des moyens 30 de comparaison auxquels sont reliés les moyens d'entrée 26 et les moyens de calcul 28. Les moyens de comparaison 30 sont propres à fournir, à l'étage 20 d'ajustement du niveau sonore, le gain de volume appliqué ($G_{Volume}$)$_{appliqué}$, suite à une comparaison entre les valeurs du gain de volume désiré $G_{Volume\ désiré}$ et le gain de volume appliqué variable ($G_{Volume}$)$_{max\ variable}$.

Les éléments décrits ici sont mis en oeuvre pour partie pour chacun des haut-parleurs des enceintes de l'installation, qui ont des caractéristiques mécaniques et/ou électriques différentes, et/ou qui doivent reproduire des signaux sources différents.

Ainsi, l'unité de commande 22 est propre à effectuer un calcul du courant instantané li pour chaque haut-parleur i et l'unité de gestion du volume sonore 24 reçoit chacun des courants instantanés $I_i$.

Le fonctionnement de l'amplificateur, notamment de l'unité 24 de gestion du volume sonore est illustrée sur la figure 2.

A l'étape 202, l'unité 24 reçoit les courants $I_i$ qui devraient circuler dans les haut-parleurs 14 pour obtenir les grandeurs dynamiques des haut-parleurs 14. Chaque courant $I_i$ est fourni par l'étage de commande 22 qui, à partir du signal musical à reproduire et du gain de volume appliqué $(G_{Volume})_{appliqué}$ présentés à l'entrée de l'étage de commande 22 détermine le courant li à faire circuler et la tension Ui à appliquer aux bornes du haut-parleur i pour obtenir les grandeurs dynamiques souhaitées.

En variante, le courant instantané li est mesuré aux bornes du haut-parleur 14.

A partir de la valeur instantanée $I_i$, la valeur efficace rms (acronyme de Root Mean Square en anglais) du courant instantané appliqué à chaque haut-parleur notée $(I_{rms})_i$ est déterminée à l'étape 204 par les moyens de calcul 28, par exemple par mise en oeuvre d'un filtre passe-bas, sur un temps choisi dépendant de la constante de temps thermique du haut-parleur.

A l'étape 206, pour chaque haut-parleur i, une valeur efficace normalisée $(I_{rms\ norm})_i$ du courant à un gain de volume unitaire est déterminée par les moyens de calcul 28, par la formule :

$$\left(I_{rms\ norm}\right)_i = \frac{\left(I_{rms}\right)_i}{G_{Volume\ désiré}}$$

où $G_{Volume\ désiré}$ est la valeur du gain de volume désiré introduit par l'utilisateur depuis les moyens d'entrée 26, et $(I_{rms})_i$ est la valeur efficace du courant instantané devant être appliqué au haut-parleur.

A l'étape 208, un gain de volume maximal $((G_{Volume})_{max})_i$ est déterminé par les moyens de calcul 28 suivant la formule :

$$\left(G_{Volume\ max}\right)_i = \frac{\left(I_{rms\ max}\right)_i}{\left(I_{rms\ norm}\right)_i}$$

où

$$\left(I_{rms\ max}\right)_i = \sqrt{\frac{\left(P_i\right)_{max}}{\left(R_e\right)_i}}$$

où $(P_i)_{max}$ puissance thermique maximale admissible pour le haut-parleur i, et
$(R_e)_i$ est la résistance électrique du haut-parleur i.

Le courant efficace maximal $(I_{rms\ max})_i$ est ainsi déterminé à partir de la résistance $(R_e)_i$ du haut-parleur et de la puissance thermique maximale admissible $(P_i)_{max}$ par le haut-parleur.

A chaque instant, le gain de volume maximal $(G_{Volume\ max})_i$ dépend donc de l'intensité efficace $(I_{rms})_i$ appliquée au haut-parleur 14 telle que déterminée lors de l'étape 204.

Un gain de volume maximal $(G_{Volume})_{max}$ pour l'ensemble des haut-parleurs 1 à n est calculé par les moyens de calcul 28 suivant la relation :

$$\left(G_{Volume}\right)_{max} = \min\left(0{,}999 \times \left(G_{Volume\ désiré}\right)_{max}, \left(G_{Volume\ max}\right)_1, ..., \left(G_{Volume\ max}\right)_n\right)$$

Cette valeur de gain de volume maximal $(G_{Volume})_{max}$ est la valeur minimale des gains de volume maximal individuels $(G_{Volume\ max})_i$ de chaque haut-parleur et du gain de volume maximal désiré $(G_{Volume\ désiré})_{max}$, lequel est réduit de 0,1% pour des raisons d'implémentation de calcul.

4

A l'étape 210, les moyens de calcul 28 intégrés à l'unité de gestion du volume sonore 24 déterminent un gain de volume appliqué variable $(G_{Volume})_{max}$ variable suivant la formule suivante :

$$\left(G_{Volume}\right)_{\text{max variable}} = \left(G_{Volume}\right)_{\text{max}} \times \left( \alpha + \left(1 - \alpha\right) \times \frac{G_{Volume\ désiré} - \left(G_{Volume}\right)_{\text{max}}}{\left(G_{Volume\ désiré}\right)_{\text{max}} - \left(G_{Volume}\right)_{\text{max}}} \right)$$

dans laquelle :

- $\alpha$ est une valeur comprise entre 0 et 1 correspondant à la proportion de puissance maximale admise à partir de laquelle une limitation en puissance commence à agir. Cette valeur est fixée à la conception de l'amplificateur.

$( G_{Volume})_{max\ variable}$ est le gain de volume appliqué variable
$( G_{Volume})_{max}$ est le gain de volume maximal
$( G_{Volume\ désiré})$ est le gain de volume désiré
$( G_{Volume\ désiré})_{max}$ est un gain de volume désiré maximum

Plus généralement, le gain de volume appliqué variable $(G_{Volume})_{max\ variable}$ est une fonction monotone croissante, par exemple une fonction affine, donnant un gain de volume appliqué variable $(G_{Volume})_{max\ variable}$ en fonction du gain de volume désiré $G_{Volume\ désiré}$ telle qu'une image du gain de volume désiré maximal $(G_{Volume\ désiré})_{max}$ par la fonction monotone soit égale au gain d'amplification maximal $(G_{Volume})_{max}$.

A l'étape 212, les moyens de comparaison 30 déterminent le gain de volume appliqué $(G_{Volume})_{appliqué}$ par l'étage d'ajustement du niveau sonore 20 comme étant le minimum du gain de volume désiré $(G_{Volume})_{désiré}$ et du gain de volume appliqué variable $(G_{Volume})_{max\ variable}$, c'est-à-dire :

$$\left(G_{Volume}\right)_{appliqué} = \min\left(G_{Volume\ desiré}, \left(G_{Volume}\right)_{\text{max variable}}\right)$$

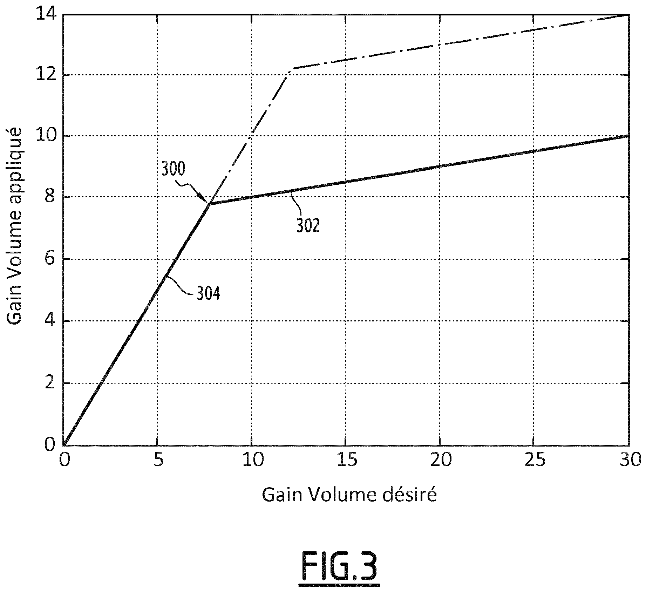

Sur la figure 3 est illustré le gain de volume appliqué $(G_{Volume})_{appliqué}$ en fonction du gain de volume désiré $(G_{Volume})_{désiré}$.

La courbe en trait continu représente la relation entre ces deux grandeurs pour un gain de volume maximal $(G_{Volume})_{max}$ égal à 10, un coefficient $\alpha$ égal à 0,8 et un gain de volume désiré maximal $(G_{Volume\ désiré})_{max}$ égal à 30.

On comprend dans ce cas que le volume appliqué $(G_{Volume})_{appliqué}$ est égal au gain de volume désiré $G_{Volume\ désiré}$ jusqu'au point d'intersection entre la fonction monotone désignée par la référence 302 et le tronçon de droite correspondante à l'identité identifié par la référence 304.

Le tronçon de droite 302 correspondant à la fonction monotone croissante passe par le point dont l'abscisse 30 est le gain de volume désiré maximal et le point dont l'ordonnée 10 correspondant au gain de volume maximal.

Son coefficient directeur, est donné par $\left( (1 - \alpha) \dfrac{(G_{Volume})_{max}}{(G_{Volume\ désiré})_{max} - (G_{Volume})_{max}} \right)$ et est proportionnel à la valeur $1-\alpha$ retenue.

En trait mixte est représentée la fonction donnant le gain de volume appliqué $(G_{Volume})_{appliqué}$ en fonction du gain de volume désiré $(G_{volume})_{désiré}$ pour un gain de volume maximal $(G_{Volume})_{max}$ égal à 14 et un coefficient $\alpha$ maintenu égal à 0,8.

On comprend qu'à chaque instant, la forme de la courbe donnant le gain de volume appliqué $(G_{Volume})_{appliqué}$ en fonction du gain de volume désiré $G_{Volume\ désiré}$ varie en fonction de la variation de la musique et des courants $I_i$.

Compte tenu du fait que les courants efficaces $(I_{rms})_i$ sont obtenus par filtrage de type passe-bas, leurs variations sont lentes au regard des variations du signal musical. Ainsi, l'éventuelle diminution du gain du volume appliqué $(G_{Volume})_{appliqué}$ est lente et ne produit pas de bruits parasites.

Le dispositif est de type prédictif et ne comporte donc pas de bouclage qui pourrait engendrer une instabilité ou un effet de pompage indésirable.

Le gain de volume appliqué pour la commande de chaque haut-parleur est a priori identique pour chaque haut-parleur. En variante, il est différent pour chacun des haut-parleurs.

Compte tenu de la présence de la fonction monotone, le procédé de limitation de la puissance thermique est telle qu'une modification du gain de volume désiré $G_{Volume\ désiré}$ par l'utilisateur entraine une modification du volume appliqué $(G_{Volume})$ appliqué avec le même sens de variation même si ce n'est pas dans les mêmes proportions tout en limitant la puissance par chaque haut-parleur.

Ainsi, l'utilisateur n'est pas dérouté par la perception d'une non prise en compte de son instruction de variation du volume désiré depuis les moyens d'entrée 26, même si l'amplificateur fonctionne à une valeur proche de sa valeur limite d'amplification.

## Revendications

1.  Procédé d'adaptation du gain de volume appliqué ($(G_{Volume})_{appliqué}$) dans un amplificateur (16) commandant au moins un haut-parleur (14) d'une enceinte en fonction du gain de volume désiré ($G_{Volume\ désiré}$) choisi par un utilisateur sur une échelle majorée par un gain de volume désiré maximal ($(G_{Volume\ désiré})_{max}$), comportant des étapes de :

    - détermination (204) de l'intensité efficace ($I_{rms}$) appliquée à au moins un haut-parleur,
    - calcul (206, 208) d'un gain de volume maximal ($(G_{Volume})_{max}$) à partir :

        - du gain de volume désiré ($G_{Volume\ désiré}$),
        - de l'intensité efficace ($I_{rms}$) appliquée au haut-parleur,
        - de caractéristiques thermiques ($(P_i)_{max}$, $(R_e)_i$) du haut-parleur,
        - du gain de volume désiré maximal ($(G_{Volume\ désiré})_{max}$),

    - calcul (210) d'une fonction monotone croissante donnant un gain de volume appliqué variable ($(G_{Volume})_{max\ variable}$) en fonction du gain de volume désiré ($G_{Volume\ désiré}$) telle que l'image du gain de volume désiré maximal ($(G_{Volume\ désiré})_{max}$) par la fonction monotone soit égale au gain de volume maximal ($(G_{Volume})_{max}$),
    - application (212) à l'amplificateur, en tant que gain de volume appliqué ($(G_{Volume})_{appliqué}$), du minimum du gain de volume désiré ($(G_{Volume})_{désiré}$) et du gain de volume appliqué variable ($(G_{Volume})_{max\ variable}$) .

2.  Procédé selon la revendication 1, **caractérisé en ce que** la fonction monotone est une fonction affine.

3.  Procédé selon la revendication 1 ou 2, **caractérisé en ce que** la fonction monotone est donnée par :

$$\left(G_{Volume}\right)_{\max\ variable} = \left(G_{Volume}\right)_{\max} \times \left( \alpha + (1-\alpha) \times \frac{G_{Volume\ désiré} - \left(G_{Volume}\right)_{\max}}{\left(G_{Volume\ désiré}\right)_{\max} - \left(G_{Volume}\right)_{\max}} \right)$$

dans laquelle $\alpha$ est une valeur comprise entre 0 et 1 ;

$(G_{Volume})_{max\ variable}$ est le gain de volume appliqué variable ;
$(G_{Volume})_{max}$ est le gain de volume maximal ;
$G_{Volume\ désiré}$ est le gain de volume désiré ; et
$(G_{Volume\ désiré})_{max}$ est un gain de volume désiré maximum.

4.  Procédé selon l'une quelconque des revendications précédentes, **caractérisé en ce qu'**une étape de calcul du gain de volume maximal individuel ($(G_{volume})_{max\ i}$) est effectuée pour chaque haut-parleur (i) à partir :

    - du gain de volume désiré ($G_{Volume\ désiré}$),
    - de l'intensité efficace ($I_{rms}$) appliquée au haut-parleur,
    - de caractéristiques thermiques ($P_i)_{max}$, $(R_e)_i$) du haut-parleur,

    et le gain de volume maximal ($G_{Volume\ max}$) est déterminé à partir des gains de volume maximal individuels ($(G_{Volume\ max})_i$).

5.  Procédé selon la revendication 4, **caractérisé en ce que** le gain de volume maximal ($G_{Volume\ max}$) est le minimum des gains de volume maximal individuels ($(G_{Volume\ max})_i$) et du gain de volume désiré maximal ($(G_{Volume\ désiré})_{max}$).

6.  Amplificateur (16) comportant :

    - des moyens (26) d'entrée d'un gain de volume désiré ($G_{Volume\ désiré}$) pour l'utilisateur par un utilisateur sur une échelle majorée par un gain de volume désiré maximal ($(G_{Volume\ désiré})_{max}$),

- des moyens d'adaptation du gain de volume appliqué ($(G_{Volume})_{appliqué}$) par l'amplificateur au moins un haut-parleur (14) d'une enceinte en fonction du gain de volume désiré ($G_{Volume\ désiré}$) choisi,

l'amplificateur comportant :

- des moyens de détermination de l'intensité efficace ($I_{rms}$) appliquée à au moins un haut-parleur,
- des moyens de calcul d'un gain de volume maximal ($(G_{Volume})_{max}$) à partir :

  - du gain de volume désiré ($G_{Volume\ désiré}$),
  - de l'intensité efficace ($I_{rms}$) appliquée au haut-parleur,
  - de caractéristiques thermiques ($(P_i)_{max}$, $(R_e)_i$) du haut-parleur,
  - du gain de volume désiré maximal ($(G_{Volume\ désiré})_{max}$),

- des moyens de calcul d'une fonction monotone croissante donnant un gain de volume appliqué variable ($(G_{Volume})_{max}$ variable) en fonction du gain de volume désiré ($G_{Volume}$ désiré) telle que l'image du gain de volume désiré maximum ($(G_{Volume\ désiré})_{max}$) par la fonction monotone soit égale au gain de volume maximal ($(G_{Volume})_{max}$),
- des moyens pour appliquer (212) à l'amplificateur, en tant que gain de volume appliqué ($(G_{Volume})_{appliqué}$), le minimum du gain de volume désiré ($G_{Volume}$ désiré) et du gain de volume appliqué variable ($(G_{Volume})_{max\ variable}$).

**Patentansprüche**

1. Anpassungsverfahren der angewendeten Lautstärkeverstärkung ($(G_{Lautstärke})_{angewendet}$) in einem Verstärker (16), der mindestens einen Lautsprecher (14) eines Bereichs steuert, abhängig von der gewünschten Lautstärkeverstärkung ($G_{Lautstärke}$ gewünscht), die von einem Benutzer auf einer Skala gewählt wird, erhöht um eine maximale gewünschte Lautstärkeverstärkung ($(G_{Lautstärke})_{gewünscht)max}$), umfassend die folgenden Schritte:

   - Bestimmen (204) der effektiven Intensität ($I_{rms}$), die auf mindestens einen Lautsprecher angewendet wird,
   - Berechnen (206, 208) einer maximalen Lautstärkeverstärkung ($(G_{Lautstärke})_{max}$) anhand:

     - der gewünschten Lautstärkeverstärkung ($G_{Lautstärke\ gewünscht}$),
     - der effektiven Intensität ($I_{rms}$), die auf den Lautsprecher angewendet wird,
     - thermischer Eigenschaften ($(P_i)_{max}$, $(R_e)_i$) des Lautsprechers,
     - der maximalen gewünschten Lautstärkeverstärkung ($(G_{Lautstärke})_{gewünscht)max}$),

   - Berechnen (210) einer steigenden monotonen Funktion, die eine variabel angewendete Lautstärkeverstärkung ($(G_{Lautstärke})_{max\ variabel}$) abhängig von der gewünschten Lautstärkeverstärkung ($G_{Lautstärke}$ gewünscht) ergibt, sodass das Bild der maximalen gewünschten Lautstärkeverstärkung ($(G_{Lautstärke})_{gewünscht)max}$) durch die monotone Funktion gleich wie die maximale Lautstärkeverstärkung ($(G_{Lautstärke})_{max}$) ist,
   - Anwenden (212) auf den Verstärker als angewendete Lautstärkeverstärkung ($(G_{Lautstärke})_{angewendet}$), des Minimums der gewünschten Lautstärkeverstärkung ($(G_{Lautstärke})$ gewünscht) und der variablen angewendeten Lautstärkeverstärkung ($(G_{Lautstärke})_{max\ variabel}$).

2. Verfahren nach Anspruch 1, **dadurch gekennzeichnet, dass** die monotone Funktion eine affine Funktion ist.

3. Verfahren nach Anspruch 1 oder 2, **dadurch gekennzeichnet, dass** die monotone Funktion durch Folgendes gegeben ist:

$$\left(G_{Volume}\right)_{\text{max variable}} = \left(G_{Volume}\right)_{\max} \times \left( \alpha + \left(1 - \alpha\right) \times \frac{G_{Volume\ désiré} - \left(G_{Volume}\right)_{\max}}{\left(G_{Volume\ désiré}\right)_{\max} - \left(G_{Volume}\right)_{\max}} \right)$$

wobei $\alpha$ ein Wert zwischen 0 und 1 ist;

$(G_{Lautstärke})_{max\ variabel}$ die variable angewendete Lautstärkeverstärkung ist;
$(G_{Lautstärke})_{max}$ die maximale Lautstärkeverstärkung ist;

$G_{\text{Lautstärke gewünscht}}$ die gewünschte Lautstärkeverstärkung ist; und
$(G_{\text{Lautstärke gewünscht}})_{\text{max}}$ eine maximale gewünschte Lautstärkeverstärkung ist.

4. Verfahren nach einem der vorherigen Ansprüche, **dadurch gekennzeichnet, dass** ein Berechnungsschritt der individuellen maximalen Lautstärkeverstärkung ($G_{\text{Lautstärke}}$ $_{\text{max } i}$) für jeden Lautsprecher (i) ausgeführt wird, anhand:

- der gewünschten Lautstärkeverstärkung ($G_{\text{Lautstärke gewünscht}}$),
- der effektiven Intensität ($I_{\text{rms}}$), die auf den Lautsprecher angewendet wird,
- thermischer Eigenschaften (($P_i)_{\text{max}}$, $(R_e)_i$) des Lautsprechers,

und wobei die maximale Lautstärkeverstärkung ($G_{\text{Lautstärke max}}$) aus den einzelnen maximalen Lautstärkeverstärkungen bestimmt wird (($G_{\text{Lautstärke}}$) $_{\text{max}}$ $_i$).

5. Verfahren nach Anspruch 4, **dadurch gekennzeichnet, dass** die maximale Lautstärkeverstärkung ($G_{\text{Lautstärke max}}$) das Minimum der individuellen maximalen Lautstärkeverstärkungen (($G_{\text{Lautstärke}}$) $_{\text{max}}$ $_i$) und der maximalen gewünschten Lautstärkeverstärkung (($G_{\text{Lautstärke gewünscht}})_{\text{max}}$) ist.

6. Verstärker (16), umfassend:

- Einrichtungen (26) zum Eingeben einer gewünschten Lautstärkeverstärkung ($G_{\text{Lautstärke gewünscht}}$) für den Benutzer durch einen Benutzer auf einer Skala, erhöht um eine maximale gewünschte Lautstärkeverstärkung (($G_{\text{Lautstärke gewünscht}})_{\text{max}}$),
- Einrichtungen zum Anpassen der angewendeten Lautstärkeverstärkung (($G_{\text{Lautstärke}})_{\text{angewendet}}$) durch den Verstärker auf mindestens einen Lautsprecher (14) eines Bereichs abhängig von der gewählten gewünschten Lautstärkeverstärkung ($G_{\text{Lautstärke gewünscht}}$),

der Verstärker umfassend:

- Einrichtungen zum Bestimmen der effektiven Intensität ($I_{\text{rms}}$), die auf mindestens einen Lautsprecher angewendet wird,
- Einrichtungen zum Berechnen einer maximalen Lautstärkeverstärkung (($G_{\text{Lautstärke}}$) $_{\text{max}}$), anhand:
- der gewünschten Lautstärkeverstärkung ($G_{\text{Lautstärke gewünscht}}$),
- der effektiven Intensität ($I_{\text{rms}}$), die auf den Lautsprecher angewendet wird,
- thermischer Eigenschaften (($P_i)_{\text{max}}$, $(R_e)_i$) des Lautsprechers,
- der maximalen gewünschten Lautstärkeverstärkung (($G_{\text{Lautstärke}}$) $_{\text{max}}$),
- Einrichtungen zum Berechnen einer steigenden monotonen Funktion, die eine variabel angewendete Lautstärkeverstärkung (($G_{\text{Lautstärke}}$) $_{\text{max variabel}}$) abhängig von der gewünschten Lautstärkeverstärkung ($G_{\text{Lautstärke gewünscht}}$) ergibt, sodass das Bild der maximalen gewünschten Lautstärkeverstärkung (($G_{\text{Lautstärke}}$) $_{\text{gewünscht}})_{\text{max}}$) durch die monotone Funktion gleich wie die maximale Lautstärkeverstärkung (($G_{\text{Lautstärke}}$) $_{\text{max}}$) ist,
- Einrichtungen zum Anwenden (212) auf den Verstärker als angewendete Lautstärkeverstärkung (($G_{\text{Lautstärke}})_{\text{angewendet}}$), des Minimums der gewünschten Lautstärkeverstärkung (($G_{\text{Lautstärke}}$) $_{\text{gewünscht}}$) und der variablen angewendeten Lautstärkeverstärkung (($G_{\text{Lautstärke}}$) $_{\text{max variabel}}$).

**Claims**

1. A method for adapting the applied volume gain (($G_{\text{Volume}})_{\text{appliqué}}$) in an audio amplifier (16) controlling at least one loudspeaker (14) of an enclosure according to the desired volume gain ($G_{\text{Volume desiré}}$) selected by a user on a scale increased by a maximum desired volume gain (($G_{\text{Volume désiré}})_{\text{max}}$), including the following steps:

- determining (204) the effective intensity ($I_{\text{rms}}$) applied to at least one loudspeaker,
- calculating (206, 208) a maximum volume gain (($G_{\text{Volume}})_{\text{max}}$) from:

- the desired volume gain ($G_{\text{Volume desiré}}$),
- the effective intensity ($I_{\text{rms}}$) applied to the loudspeaker,
- thermal characteristics (($P_i)_{\text{max}}$, $(R_e)_i$) of the loudspeaker,
- the maximum desired volume gain (($G_{\text{Volume désiré}})_{\text{max}}$),

- calculating (210) an increasing monotonic function providing an variable applied volume gain ($(G_{Volume})_{max\ variable}$) according to the desired volume gain ($G_{Volume\ désiré}$) such that the image of the maximum desired volume gain ($(G_{Volume\ désiré})_{max}$) by the monotonic function is equal to the maximum volume gain ($(G_{Volume})_{max}$),

- applying (212), to the amplifier, as applied volume gain ($(G_{Volume})_{appliqué}$), the minimum of the desired volume gain ($(G_{Volume})_{désiré}$) and the variable applied volume gain ($(G_{Volume})_{max\ variable}$).

2. The method according to claim 1, **characterized in that** the monotonic function is an affine function.

3. The method according to claim 1 or 2, **characterized in that** the monotonic function is provided by:

$$\left(G_{Volume}\right)_{\text{max variable}} = \left(G_{Volume}\right)_{\text{max}} \times \left( \alpha + \left(1 - \alpha\right) \times \frac{G_{Volume\ désiré} - \left(G_{Volume}\right)_{\text{max}}}{\left(G_{Volume\ désiré}\right)_{\text{max}} - \left(G_{Volume}\right)_{\text{max}}} \right)$$

in which $\alpha$ is a value comprised between 0 and 1;

$(G_{Volume})_{max\ variable}$ is the variable applied volume gain;
$(G_{Volume})_{max}$ is the maximum volume gain;
$G_{Volume\ désiré}$ is the desired volume gain; and
$(G_{Volume\ désiré})_{max}$ is a maximum desired volume gain.

4. The method according to any one of the preceding claims, **characterized in that** a step for calculating the individual maximum volume gain ($(G_{Volume})_{max\ i}$) is carried out for each loudspeaker (i) from:

- the desired volume gain ($G_{Volume\ desiré}$),
- the effective intensity ($I_{rms}$) applied to the loudspeaker,
- thermal characteristics ($(P_i)_{max}$, $(R_e)_i$) of the loudspeaker,

and the maximum volume gain ($G_{Volume\ max}$) is determined from individual maximum volume gains ($G_{Volume\ max})_i$).

5. The method according to claim 4, **characterized in that** the maximum volume gain ($G_{Volume\ max}$) is the minimum of the individual maximum volume gains ($(G_{Volume\ max})_i$) and the maximum desired volume gain ($G_{Volume\ désiré})_{max}$).

6. An amplifier (16), including:

- input means (26) for a desired volume gain ($G_{Volume\ désiré}$) for the user by a user on a scale increased by a maximum desired volume gain ($(G_{Volume\ désiré})_{max}$),
- means for adapting the applied volume gain ($(G_{Volume})_{appliqué}$) by the amplifier of at least one loudspeaker (14) of an enclosure according to the selected desired volume gain ($G_{Volume\ désiré}$),

the amplifier including:

- means for determining the effective intensity ($I_{rms}$) applied to at least one loudspeaker,
- means for calculating a maximum volume gain ($(G_{Volume})_{max}$) from:

  - the desired volume gain ($G_{Volume\ désiré}$),
  - the effective intensity ($I_{rms}$) applied to the loudspeaker,
  - thermal characteristics ($(P_i)_{max}$, $(R_e)_i$) of the loudspeaker,
  - the maximum desired volume gain ($(G_{Volume\ désiré})_{max}$),

- means for calculating an increasing monotonic function providing an variable applied volume gain ($(G_{Volume})_{max\ variable}$) according to the desired volume gain ($G_{Volume\ désiré}$) such that the image of the maximum desired volume gain ($(G_{Volume\ désiré})_{max}$) by the monotonic function is equal to the maximum volume gain ($(G_{Volume})_{max}$),
- means for applying (212), to the amplifier, as applied volume gain ($(G_{Volume})_{appliqué}$), the minimum of the desired volume gain ($(G_{Volume})_{désiré}$) and the variable applied volume gain ($(G_{Volume})_{max\ variable}$).

## FIG.1

## FIG.2

FIG.3